Europäisches Patentamt

European Patent Office

Office européen des brevets

(11) Numéro de publication: **0 285 524 B1**

# FASCICULE DE BREVET EUROPEEN

(45) Date de publication de fascicule du brevet: **29.12.93** (51) Int. Cl.5: **H01P 5/12**, H03C 7/02, G01S 7/28

(21) Numéro de dépôt: **88400804.6**

(22) Date de dépôt: **01.04.88**

(54) **dispositif comportant un combineur radial pour ondes électromagnétiques.**

(30) Priorité: **03.04.87 FR 8704726**

(43) Date de publication de la demande:
**05.10.88 Bulletin 88/40**

(45) Mention de la délivrance du brevet:
**29.12.93 Bulletin 93/52**

(84) Etats contractants désignés:
**DE FR GB IT NL**

(56) Documents cités:
**US-A- 4 477 781**

**R.C.A. REVIEW, vol. 42, no. 4, décembre 1981,
pages 596-616, Princeton, New Jersey, US;
M. KUMAR; "Dual-gate FET phase shifter"**

**IEEE TRANSACTIONS ON MICROWAVE
THEORY AND TECHNIOUES, vol. MTT-32, no.
3, mars 1984, pages 317-324, IEEE, New York,
US; J. GOEL; "A K-band GaAs FET amplifier
with 8,2-W output power"**

**M.I. SKOLNIK; "Radar Handbook", 1970, pages 7-58/59, McGraw-Hill, Inc., New York, US**

(73) Titulaire: **THOMSON-CSF
51, Esplanade du Général de Gaulle
F-92800 Puteaux(FR)**

(72) Inventeur: **Baril, Michel
THOMSON-CSF
SCPI
19, avenue de Messine
F-75008 Paris(FR)**

(74) Mandataire: **Benoit, Monique et al
THOMSON-CSF
SCPI
B.P. 329
50, rue Jean-Pierre Timbaud
F-92402 Courbevoie Cédex (FR)**

## Description

L'invention a principalement pour objet un dispositif comportant un combineur radial pour ondes électromagnétiques et procédé mettant en oeuvre un combineur radial.

L'utilisation du combineur radial selon la présente invention permet notamment d'effectuer une modulation d'amplitude et/ou de phase du signal à émettre en effectuant une modulation de phase des divers amplificateurs ou émetteurs connectés dans ledit combineur.

La baisse des prix et l'amélioration des performances des dispositifs à semiconducteur leur permet de remplacer des dispositifs à tubes, même dans le domaine qui jusqu'ici était réservé à ces derniers. Cela est notamment vrai dans les émetteurs d'ondes électromagnétiques, notamment pour les émissions radiophoniques, les émissions de télévision ou les radars.

Pour ces applications, il est fréquent d'utiliser une pluralité d'émetteurs ou amplificateurs transistorisés couplés à une antenne unique chaque émetteur fournissant une partie de la puissance totale rayonnée. L'assemblage d'une pluralité d'émetteurs pose des problème d'encombrement ainsi que des couplages des émetteurs avec antenne.

Un des avantages d'utiliser une pluralité d'émetteurs est de pouvoir fonctionner en présence d'une panne de certains émetteurs. Le combineur radial utilisé dans le dispositif selon la présente invention comporte des résistances permettant d'absorber l'énergie susceptible de perturber le fonctionnement du dispositif en cas de panne de certains émetteurs.

La modulation d'amplificateurs transistorisés fonctionnant en classe B ou C est plus difficile que celle, comportant des tubes, par exemple de type Klystron. Cet inconvénient est particulièrement important à faible amplitude. En effet, les amplificateurs ou émetteurs transistorisés fonctionnant en classe B ou C ne fournissent une puissance de sortie qu'à partir d'un seuil. La transition autour du seuil est brutale générant un spectre de lobe secondaire de fréquence d'amplitude importante. De plus, il n'est pas possible de modifier la forme des impulsions émises en utilisant de tels émetteurs par une modulation du signal d'entrée.

On connaît d'après le document R.C.A. REVIEW, Vol. 42, n° 4, décembre 1981, Princeton, NEW JERSEY, USA, M. KUMAR : "Dual-gate FET phase shifter", un déphaseur à combineur radial, mais il n'est pas question d'éliminer des défauts de son signal de sortie.

On connaît d'autre part d'après le document IEEE TRANSACTIONS ON MICROWAVE THEORY AND TECHNIQUES, Vol. MTT-32, n° 3, mars 1984, NEW YORK, US, J. GOEL : "A K-band GaAs FET amplifier with 8.2-W output power", un combineur radial pour lequel il n'est pas question de modifier la phase des signaux d'entrée des amplificateurs reliés à ce combineur.

Dans le dispositif selon la présente invention, la variation de phase apportée à certains émetteurs connectés à l'entrée d un combineur radial permet d'obtenir des interférences constructives ou destructives lors de la combinaison du signal. Ainsi selon la valeur des déphasages appliqués, il est possible d'obtenir une plus ou moins forte amplitude émise. Il est possible ainsi d'effectuer notamment la modulation de forme de l'impulsion émise, par exemple pour minimiser les lobes secondaires fréquentiels générés par ces impulsions.

L'invention a principalement pour objet un dispositif d'émission d'ondes électromagnétiques comprenant un combineur radial pour ondes électromagnétiques comportant une pluralité d'entrées connectées à une pluralité d'adaptateurs d'impédance, des émetteurs ou amplificateurs étant connectés aux entrées du combineur radial, des points équipotentiels en fonctionnement normal des adaptateurs d'impédance étant reliés par des résistances, caractérisé par le fait qu'au moins une partie desdits amplificateurs ou émetteurs fonctionnent en classe C et sont reliés à des sources de signaux par l'intermédiaire d'un dispositif de traitement comportant un déphaseur.

L'invention sera mieux comprise au moyen de la description ci-après et des figures annexées données comme des exemples non limitatifs parmi lesquels :

- la figure 1 est une vue en coupe d'un combineur radial mis en oeuvre dans le dispositif selon la présente invention ;
- la figure 2 est une vue écorchée du combineur radial de la figure 1 ;
- la figure 3 est un schéma d'un premier exemple de réalisation d'un dispositif d'émission selon la présente invention ;
- la figure 4 est un schéma d'un deuxième exemple de réalisation d'un dispositif d'émission selon la présente invention ;
- la figure 5 est un schéma d'un troisième exemple de réalisation d'un dispositif d'émission selon la présente invention ;
- la figure 6 est un schéma d'un exemple de réalisation du système de traitement des figures 4 ou 5 ;

- la figure 7 est un schéma d'un combineur radial susceptible d'être mis en oeuvre dans le dispositif selon la présente invention ;
- la figure 8 est un schéma illustrant les connexions d'un dispositif selon la présente invention ;
- la figure 9 est un schéma illustrant les connexions d'un dispositif selon la présente invention ;
- la figure 10 est un schéma illustrant les connexions d'un dispositif selon la présente invention ;
- la figure 11 est un schéma illustrant le principe d'une modulation amplitude/phase susceptible d'être mise en oeuvre dans le dispositif selon la présente invention ;
- la figure 12 est un schéma d'un dispositif d'émission radiophonique mettant en oeuvre le dispositif selon la présente invention ;
- la figure 13 est un schéma d'un dispositif selon la présente invention ;
- la figure 14 est un exemple de réalisation d'un circuit de traitement mis en oeuvre dans le dispositif selon la présente invention ;
- la figure 15 est un schéma illustrant un premier exemple de transmission numérique ;
- la figure 16 est un schéma illustrant un deuxième exemple de transmission numérique ;
- la figure 17 est un schéma illustrant un troisième exemple de transmission numérique ;
- la figure 18 illustre la possibilité de modulation d'impulsions par un dispositif selon la présente invention.
- la figure 19 illustre le lissage du signal susceptible d'être effectué par le circuit de traitement de la figure 14.

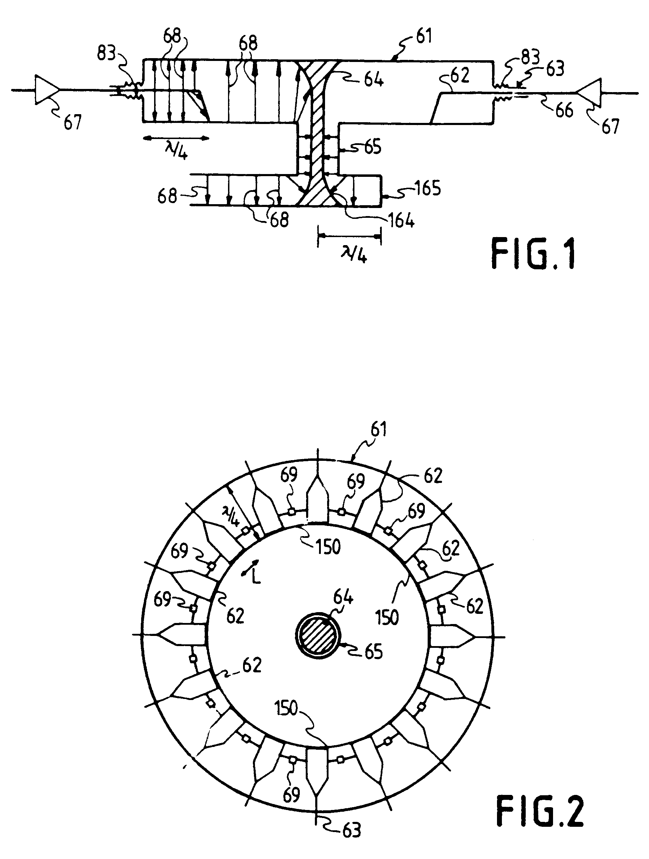

Sur les figures 1 à 19 on a utilisé les mêmes références pour désigner les mêmes éléments.

Sur les figures 1 et 2, on peut voir un combineur radial 61. Le combineur radial 61 permet de combiner l'énergie électromagnétique provenant d'une pluralité d'émetteurs ou amplificateurs 67 disposés radialement de façon à pouvoir alimenter un guide d'onde, non représenté. Les sorties des amplificateurs ou émetteurs 67 sont reliées à des transformateurs d'impédance 62, par exemple par l'intermédiaire des câbles coaxiaux 63. L'utilisation des câbles coaxiaux est rendue possible par le fait que chaque amplificateur ou émetteur 67 ne génère qu'une faible partie de l'énergie totale, susceptible d'être émise. Avantageusement, les câbles coaxiaux 63 sont reliés au combineur radial 61 par l'intermédiaire des connecteurs comportant un pas de vis 83. Les transformateurs d'impédance 62 comportent par exemple des palettes connectées à l'âme 66 des câbles coaxiaux 63 disposés régulièrement sur la périphérie cylindrique du combineur radial 61. Le conducteur extérieur du câble coaxial 63 est relié à la masse constituée par la structure du combineur radial 61. Les palettes ont une longueur sensiblement égale à $\lambda/4$, $\lambda$ étant la longueur d'onde guidée de la fréquence centrale de la bande passante à laquelle le combineur radial est destiné. La largeur L de chaque palette du transformateur d'impédance 62 est choisie de manière à optimiser l'adaptation d'impédance entre le câble coaxial 63 et la cavité du combineur radial 61. L'extrémité des palettes des transformateurs d'impédance 62 est ramenée à la masse. Dans l'exemple illustré sur la figure 1, les extrémités sont connectées au bâti intérieur du combineur radial 61. Le bâti du combineur radial 61 est prolongé, en son centre, en bas dans l'exemple de réalisation illustré sur la figure 1 par un guide d'onde 65 dont le centre comporte une pièce métallique 64 permettant le couplage de la cavité du combineur radial 61 avec le guide d'onde 65. La pièce 64 est une pièce métallique ayant une symétrie de révolution et a une forme évasée vers la paroi supérieure du combineur radial 61. La pièce métallique 64 est appelée door knob en terminologie anglo-saxonne dans la mesure où elle rappelle un bouton de porte.

Le guide d'onde 65 est relié à un guide d'onde 165. Au niveau du guide d'onde 165 la pièce métallique 64 est terminée par une pièce évasée 164 analogue à la pièce 64.

Les flèches portant la référence 68 sur la figure 1 symbolisent la répartition du champ électrique. La répartition du champ électrique est symétrique dans le câble coaxial 63. Au niveau des adaptateurs d'impédance 62 le champ est réparti symétriquement en haut et en bas des palettes. Progressivement le champ est réparti asymétriquement entre le haut et le bas de la structure du combineur radial 61.

L'ensemble des transformateurs d'impédance 62 réparti régulièrement à la périphérie d'un cercle génère une onde circulaire. Au niveau des guides d'onde 65 comportant une âme métallique le champ a une structure symétrique. Dans les guides d'onde 165 le champ a de nouveau une structure asymétrique comportant des différences de potentiel entre la paroi haute et la paroi basse. Le guide d'onde 165 est par exemple un guide d'onde à sections rectangulaires. La transmission d'énergie est rendue possible par la présence des pièces métalliques 64 et 164. Le centre de la pièce 164 est disposée à une distance égale à $\lambda/4$ du commencement du guide d'onde 165.

Avantageusement, les extrémités des palettes constituant les adaptateurs d'impédance 62 sont reliées entre elles par un conducteur métallique 150.

Au cas où un des amplificateurs ou émetteurs 67 serait en panne l'ensemble du rayonnement émis par les palettes des transformateurs d'impédance 62 ne formerait plus une onde cylindrique. Dans ce cas, il est possible qu'il se crée des modes d'ordre supérieurs perturbant le bon fonctionnement du combineur 61.

Avantageusement, des résistances 69 relient les palettes des transformateurs d'impédance 62 en des points qui en fonctionnement normal seront au même potentiel sur chaque palette.

Ainsi en fonctionnement normal les deux bornes des résistances 69 étant portées au même potentiel, les résistances 69 ne dissipent aucune énergie. Leur présence est transparente pour le fonctionnement du dispositif. Par contre, en cas de panne d'un, ou plusieurs amplificateurs ou émetteurs 67, il se crée une différence de potentiel, entre les palettes des transformateurs d'impédance 62. Les résistances 69 absorbent dans ce cas l'excédent d'énergie, qui autrement risquerait de perturber le bon fonctionnement du combineur 61.

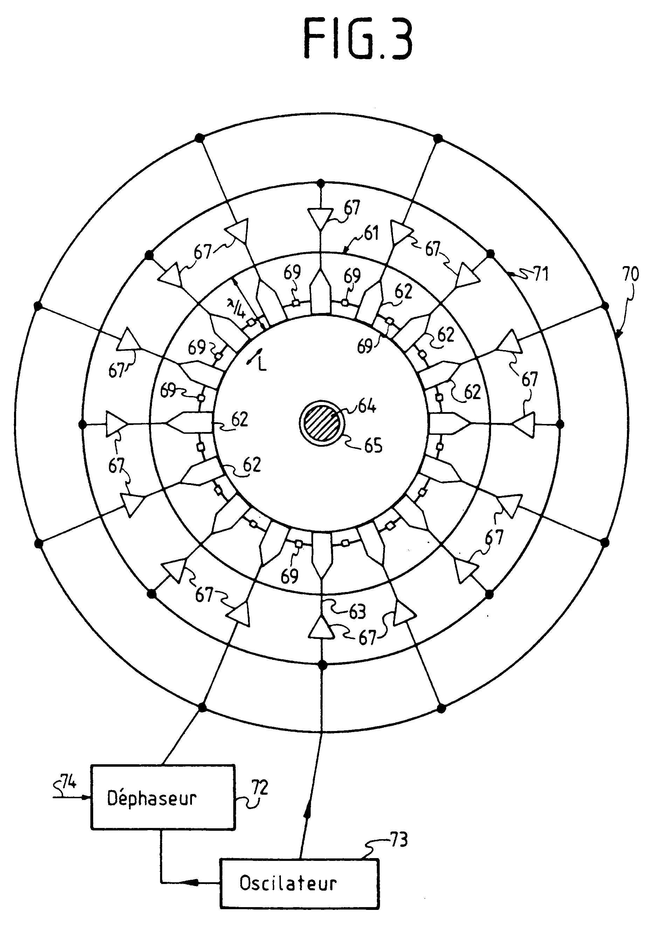

Sur la figure 3, on peut voir un dispositif d'émission comportant un combineur radial 61 auquel sont connectés deux ensembles d'amplificateurs et émetteurs 67.

L'oscillateur pilote 73 est connecté directement à un premier ensemble d'amplificateurs ou émetteurs 67 par l'intermédiaire d'un dispositif de connexion 71.

L'oscillateur pilote 73 est connecté à un second ensemble d'amplificateurs et émetteurs 67 par l'intermédiaire d'un déphaseur 72 et d'un second dispositif de connexion 70. Le déphaseur 72 reçoit un signal de commande 74 permettant de faire varier le retard de phase par exemple entre 0 et Π.

Avantageusement, les amplificateurs et émetteurs 67 étant disposés radialement, un amplificateur ou émetteur 67 sur deux est relié à un dispositif de connexion 71 les autres amplificateurs et émetteurs 67 sont reliés au dispositif de connexion 70.

Quand le déphasage introduit par le déphaseur 72 est nul tous les signaux présents à l'entrée de tous les amplificateurs et émetteurs 67 sont en phase.

Dans un tel cas, la puissance disponible à la sortie du combineur radial 61 est maximale. Cette énergie est égale, si l'on néglige les pertes à la somme des énergies fournies par tous les amplificateurs ou émetteurs 67.

Lorsque le déphaseur 72 induit un déphasage de Π, l'amplitude du signal présent à la sortie du combineur radial 61 est nulle. La variation continue ou quasi continue du déphasage engendré par le déphaseur 72 permet de passer de la valeur nulle à la valeur maximale du signal en sortie du combineur radial 61. Ainsi, il est possible d'effectuer une modulation du signal disponible en sortie du combineur radial 61.

Cette modulation peut s'appliquer aussi bien de façon continue au signal qu'à une modulation d'impulsion. Cette modulation est possible même dans le cas d'utilisation d'amplificateurs ou émetteurs 67 transistorisés, présentant un seuil en dépit duquel il ne délivre pas le signal de sortie. De plus, le dispositif selon la présente invention permet la modulation d'amplitude tout en utilisant des amplificateurs travaillant en classe C, éventuellement en régime saturé. L'utilisation d'amplificateurs en classe C permet de bénéficier d'un excellent rendement et des autres avantages propres à cet amplificateur.

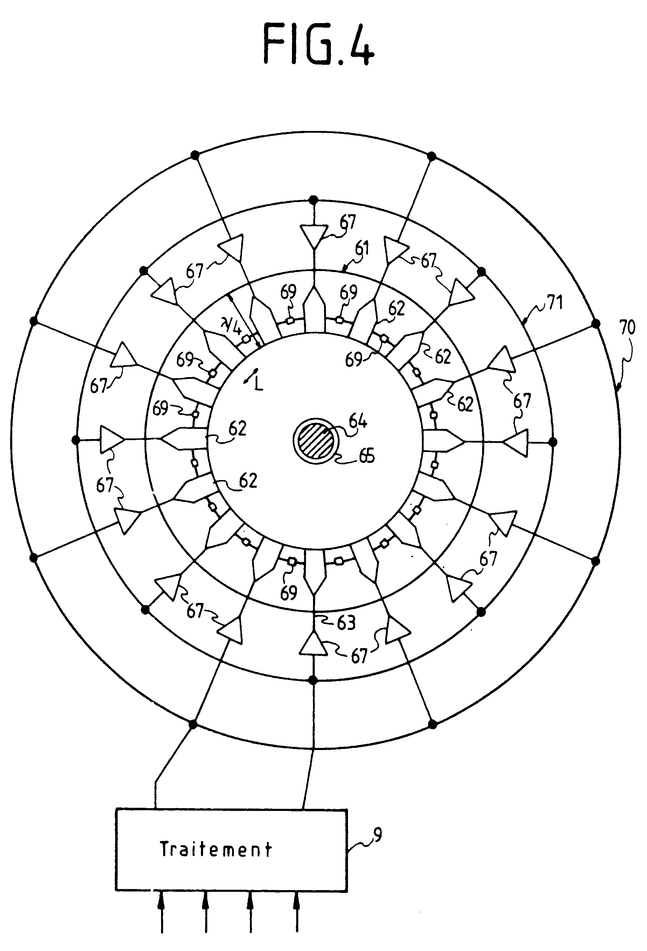

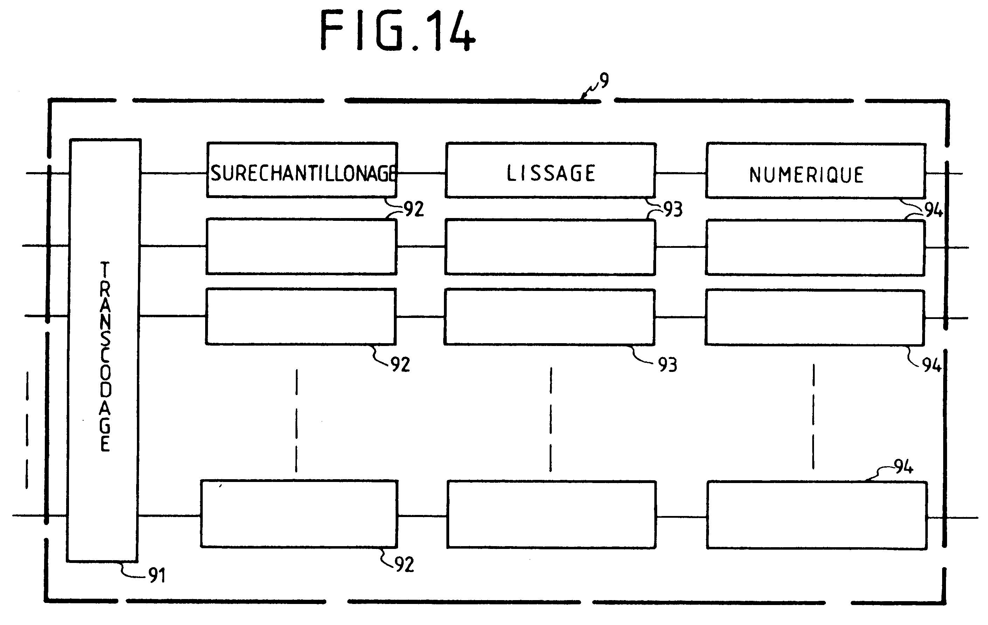

Sur la figure 4, on peut voir un dispositif utilisant un combineur radial 61 permettant la modulation d'amplitude et de phase du signal disponible en sortie du combineur radial 61. Le dispositif de la figure 4 comporte un circuit de traitement 9 dont le fonctionnement sera illustré sur la figure 14.

Dans l'exemple de réalisation du dispositif selon la présente invention illustré sur la figure 4 le circuit de traitement 9 comporte une pluralité d'entrées et deux sorties reliées à un dispositif de connexions, respectivement 70 et 71. Le dispositif de traitement 9 permet d'associer aux valeurs des signaux à transmettre les phases permettant d'obtenir le signal d'émission désiré.

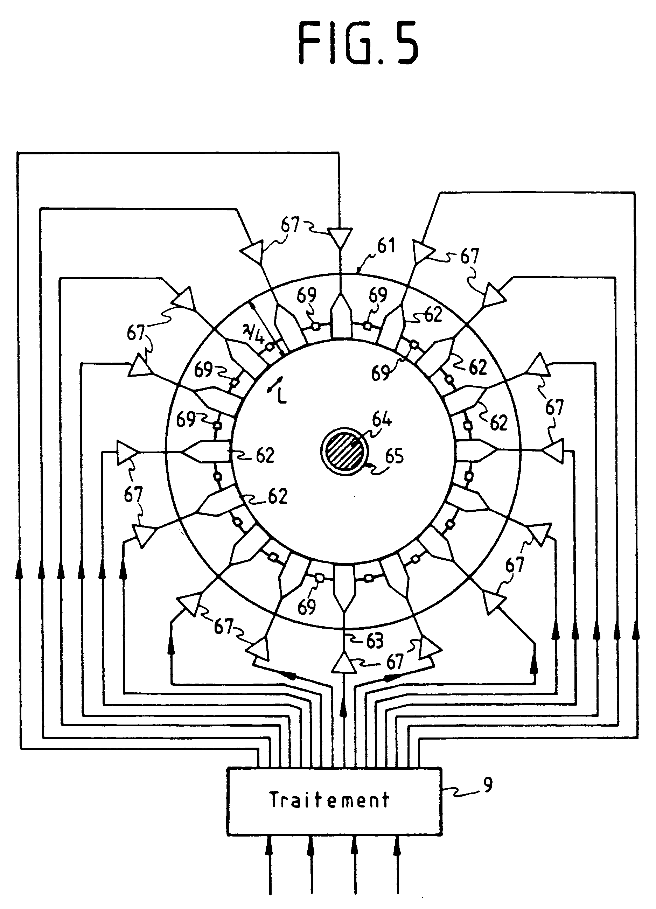

Dans l'exemple illustré sur la figure 5, le circuit de traitement 9 permet de fournir à chaque amplificateur ou émetteur 67 la phase nécessaire à l'obtention de la modulation désirée.

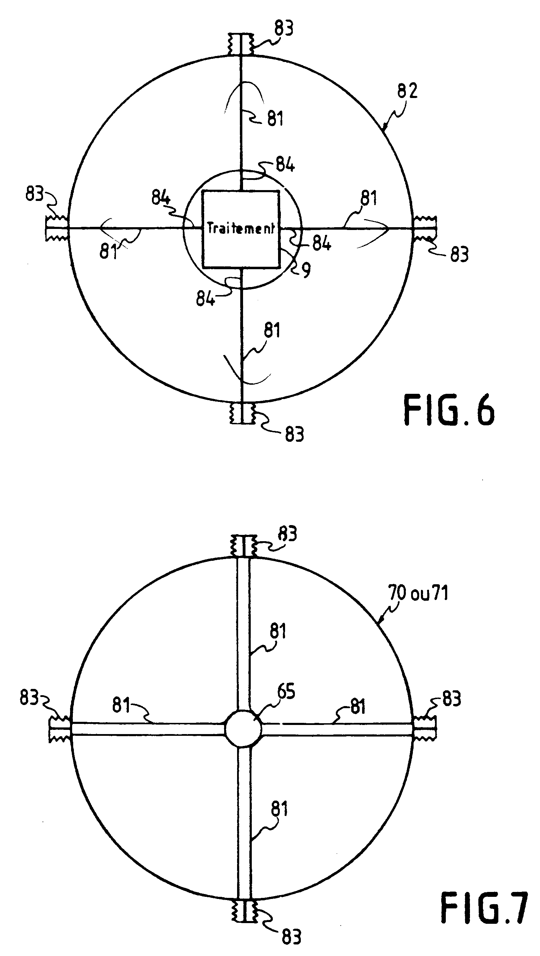

Sur la figure 6, on peut voir un dispositif 82 permettant la connexion des circuits de traitement 9. Les circuits de traitement 9 sont rendus solidaires d'un dispositif et connexion circulaire 82. Les sorties du circuit 9 sont reliées à des pistes, par exemple microstrips disposées radialement sur le dispositif 82.

Dans un premier exemple de réalisation du dispositif selon la présente invention les sorties du circuit de traitement 9 sont directement connectées aux pistes 81. Dans une seconde variante de réalisation du dispositif selon la présente invention les sorties du circuit de traitement 9 sont connectées par l'intermédiaire des fils 84 aux pistes 81.

Les pistes 81 aboutissent par exemple à des connecteurs 83.

Conformément à la technologie microstrip la seconde face du dispositif 82 présente un plan de masse. Toutefois, ce plan de masse est traversé par les connexions nécessaires aux entrées du circuit traitement 9. Ces entrées ne sont pas représentées sur la figure 6.

Dans une variante de réalisation du dispositif de la figure 6 les entrées du circuit de traitement 9 sont elles aussi connectées par l'intermédiaire des pistes 81 du dispositif 82. Sur la figure 6, on a représenté un circuit de traitement 9 comportant uniquement quatre sorties. Il est bien entendu que la réalisation du dispositif 82 comportant un nombre supérieur de sorties ne sort pas du cadre de la présente invention.

Sur la figure 7, on peut voir un exemple de réalisation particulièrement avantageux des circuits de connexion 70 ou 71. Le dispositif de connexion 70 ou 71 comporte des pistes 81 réalisées en technologie microstrip assurant la connexion entre une entrée 65 et, par exemple des connecteurs 83. La seconde face, conformément à la technologie microstrip du dispositif de connexion 70 ou 71 est métallisée afin de constituer le plan de masse. Les points d'entrée 65 traversent avantageusement ce plan de masse, tout en étant isolés par rapport à celui-ci.

Sur la figure 7 on a représenté uniquement quatre pistes 81. L'utilisation d'un nombre supérieur des pistes 81 ne sort pas du cadre de la présente invention.

Dans une variante de réalisation du dispositif de connexion 70 et 71 on utilise deux plans isolés pour réaliser les pistes 81 du dispositif de connexion 70 et du dispositif de connexion 71. Avantageusement, on dispose d'un plan de masse entre les plans des pistes 81 du dispositif de connexion 70 et celui comportant les pistes 81 du dispositif de connexion 71. Avantageusement, l'entrée de ce dispositif est constitué par trois conducteurs coaxiaux. Le conducteur central sert de conducteur extérieur au câble coaxial constitué par les deux premiers conducteurs et de conducteurs intérieurs au câble coaxial constitué par les deux derniers conducteurs.

Il est bien entendu que les dispositifs de connexion 70, 71 peuvent être reliés aux entrées des amplificateurs ou émetteurs 67 par l'intermédiaire de lignes, par exemple de câbles coaxiaux.

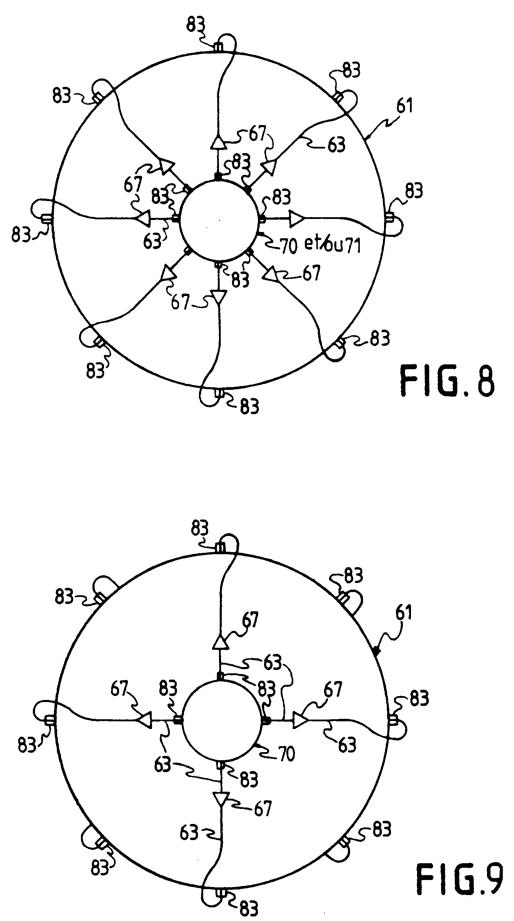

Sur la figure 8 on peut voir un exemple de réalisation du dispositif selon la présente invention comportant un dispositif de connexion 70 et 71 disposé sur un combineur radial 61. Les sorties du dispositif de connexion 70 et/ou 71 sont connectées par exemple par l'intermédiaire de connecteurs 83 et des câbles coaxiaux 63 à des amplificateurs ou émetteurs 67. Les amplificateurs ou émetteurs 67 sont connectés aux entrées du combineur radial 61. Les entrées du dispositif de connexion 70 et/ou 71 ne sont pas représentées sur la figure 8.

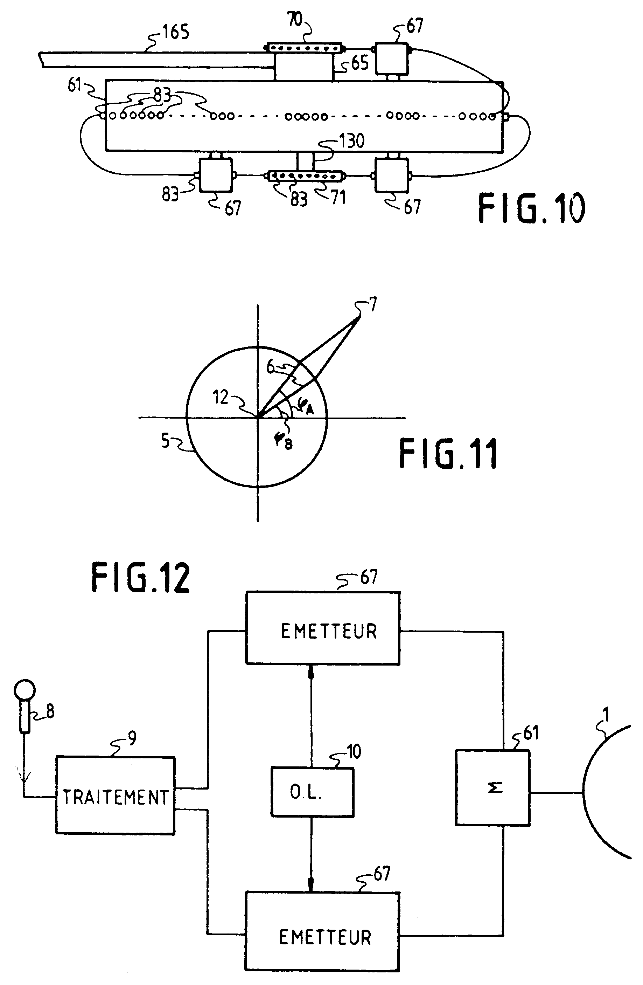

Sur la figure 9, on peut voir un exemple de réalisation du dispositif selon la présente invention comportant un connecteur 70 disposé sur une face d'un combineur radial 61 ; le dispositif de connexion 71 étant disposé sur l'autre face dudit combineur n'est pas visible sur la figure 9. Les sorties du dispositif de connexion 70 sont connectées aux entrées des amplificateurs ou émetteurs 67, par exemple par l'intermédiaire des connecteurs 83 et des câbles coaxiaux 63. Les amplificateurs et émetteurs 67 sont représentés par leur symbole sur la figure 9. Les sorties des amplificateurs ou émetteurs 67 sont reliées, par exemple par l'intermédiaire des connecteurs 83 et des câbles coaxiaux 63 aux entrées du combineur radial 61. Il en est de même du dispositif de connexion 71 disposé sur l'autre face du combineur radial 61.

Avantageusement, une entrée sur deux du combineur radial 61 est connectée au dispositif de connexion 70, les autres entrées étant connectées au dispositif de connexion 71 ; les entrées connectées au dispositif de connexion 70 alternent avec celles connectées au dispositif de connexion 71.

Sur la figure 10, on peut voir une vue de profil du dispositif de la figure 9 sur laquelle on a de plus représenté le guide d'onde 165 susceptibles d'être connectés à une antenne d'émission non représentée sur la figure 10. Sur la figure 10 seuls trois amplificateurs ou émetteurs 67 ont été représentés sous forme de cartes électroniques. Il est bien entendu que de telles cartes seront maintenues en place par le dispositif de type connu. Le dispositif de connexion 70 est disposé sur le guide d'onde 65. Le dispositif de connexion 71 est disposé sur un espaceur 130 permettant une disposition symétrique assurant le même retard de phase dû au chemin parcouru par le signal. Sur les figures 10 seuls trois amplificateurs et/ou émetteurs 67 ont été représentés.

Sur la figure 11, on peut voir le principe de la modulation amplitude/phase susceptible d'être mis en oeuvre par le dispositif selon la présente invention. Sur la figure 11 on a représenté en coordonnées polaires le signal 6 susceptible d'être combiné dans le combineur radial 61. Le module représente l'amplitude du signal émis, l'angle la phase. Le cercle 5 représente l'amplitude des émetteurs 6 ou de deux ensembles d'émetteurs 67 utilisés. Un premier signal 6 correspond à une phase $\phi$A, le second signal 6 correspond à une phase $\phi$B. Le signal résultant 7 est obtenu par addition vectorielle des signaux 6 issus des deux émetteurs.

Ainsi, on peut voir, que la modulation appropriée des phases $\phi$A et $\phi$B des deux émetteurs 6 permet d'obtenir un signal 7 modulé en amplitude et en phase.

Avantageusement, on utilise le procédé et le dispositif selon la présente invention pour obtenir des transmissions numériques des données.

Sur la figure 12, on peut voir un exemple de réalisation d'un dispositif d'émission utilisant la modulation amplitude-phase.

Le dispositif comporte au moins une source 8 des signaux à transmettre, par exemple un microphone. La source des signaux 8 est connectée à un dispositif de traitement 9. Le dispositif de traitement 9 convertit le signal reçu en signaux de commande d'émetteurs 67, (ou de dispositifs de modulation de phase non représentée sur la figure 12), permettant d'obtenir les phases nécessaires permettant la génération d'un signal qui est fonction du signal à transmettre. Le dispositif de traitement est connecté à au moins deux émetteurs 67.

Avantageusement, un oscillateur local 10 est connecté aux émetteurs 2 permettant une augmentation de fréquence. Il est possible d'utiliser plusieurs étages (non représentés) pour augmenter la fréquence. Les signaux issus des émetteurs 2 sont sommés par un combineur radial 61.

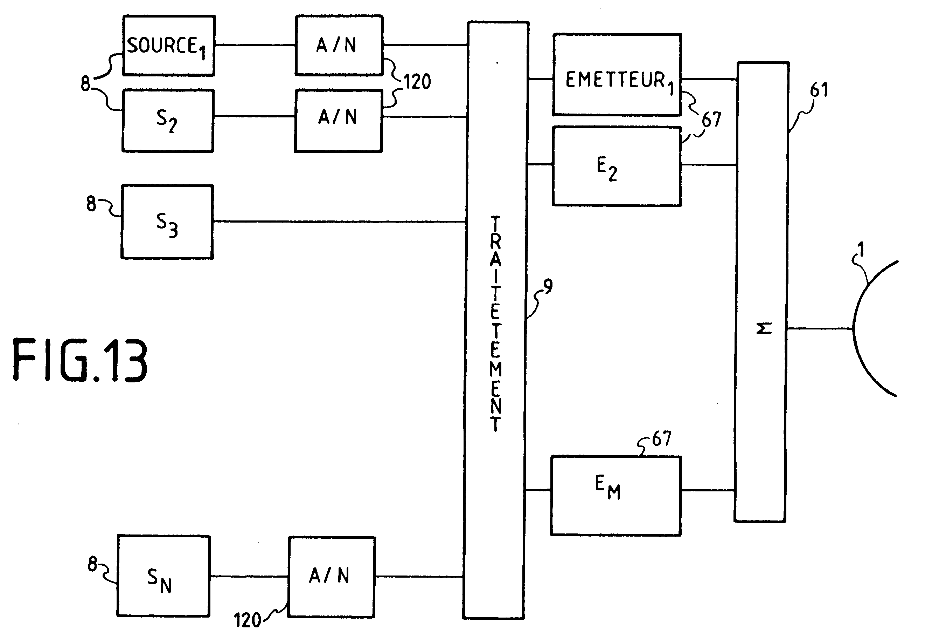

Sur la figure 13, on peut voir un exemple de réalisation d'un dispositif de transmission selon l'invention comportant N sources de signal 8. Dans l'exemple illustré sur la figure 13, un dispositif effectif effectue des transmissions numériques. Ainsi dans le cas ou on utilise des sources de signal analogique il faut numériser ce signal. La numérisation du signal est obtenue soit par le dispositif de traitement 9, soit comme illustré sur la figure 13 par des convertisseurs analogiques-numériques 120 placés en amont du dispositif de traitement 9. Il est bien entendu que seules les sources 8 de signal analogique sont connectées à des convertisseurs analogiques-numériques 120. Le dispositif de traitement 9 est connecté à M émetteurs 67. Les M émetteurs 67 sont connectés à un combineur radial 61. Le combineur radial 61 est relié à une antenne 1. Le dispositif de traitement 9 délivre aux émetteurs 67 les références de phase nécessaires à l'obtention de la modulation amplitude-phase désirée. Le dispositif illustré sur la figure 13 permet d'effectuer des transmissions simultanées de plusieurs voies par un canal de transmission unique ou au contraire, selon les conditions de transmissions et les débits désirés, la transmission d'une voie unique sur une pluralité de canaux de transmission. Par exemple, on transmet sur une première fréquence de la porteuse les informations nécessaires à l'obtention d'un programme de télévision et sur une seconde fréquence de la porteuse des informations complémentaires nécessaires à l'obtention d'images en haute définition.

Avantageusement, le dispositif de traitement 9 permet de modifier le signal à émettre par exemple le dispositif de traitement 9 modifie l'équilibre chromatique d'un signal vidéo couleur ou effectue un filtrage des aigus d'un signal sonore.

L'utilisation de transmission numérique permet de rendre indépendantes les informations à transmettre du canal de transmission. Ainsi il est possible d'utiliser le dispositif selon la présente invention notamment pour effectuer des émissions de radio, de télévision, de transmission sur par exemple faisceau hertzien ou d'émissions d'impulsion radar modulée.

Sur la figure 14, on peut voir un dispositif de traitement 9 permettant de répartir N sources de signal 8 (non illustrées sur la figure 6) sur M émetteurs 67 (non illustrés sur la figure 14).

Le dispositif 9 comporte un dispositif de transcodage 91. Le dispositif de transcodage 91 permet de fournir aux émetteurs 2 les signaux nécessaires à l'émission. Par exemple; dans le cas d'une source de signal 8 unique et de deux émetteurs 67 on transmet un signal utile complexe $x(t) = \rho(t) . e^{j\phi(t)}$ modulé en BLU autour d'une fréquence $f_0$.

Les signaux émis $e(t)$ sont donnés par la formule :

$$e(t) = \text{Réel}\,[x(t) . e^{j2\pi f_0 t}]$$
$$e(t) = \rho(t)\,\text{Réel}\,[e^{j(2\pi f_0 t + (t))}]$$
$$e(t) = \rho(t)\cos(2\pi f_0 + \phi(t))$$

Posons $\Delta\phi(t) = \text{Arc cos } \rho(t)/2$.

Ainsi on obtient les signaux de modulation d'un premier émetteur 67 :

$$x_1(t) = e^{j\phi(t) + \Delta\phi(t)}$$

et le signal de modulation du second émetteur 67 :

$$x_2(t) = e^{j\phi(t) - \Delta\phi(t)}$$

A la sortie du combineur radial 67 on obtient un signal

$$e'(t) = \text{Réel}\,[x_1(t) . e^{j2\pi f_0 t}] + \text{Réel}\,[x_2(t) . e^{j2\pi f_0 t}]$$
$$e'(t) = \text{Réel}\,[[(x_1(t) + x_2(t)]\, e^{j2\pi f_0 t}]$$

$$e'(t) = \text{Réel} \left[\left[2 \; \frac{e^{j \, \Delta\varphi(t)} - e^{j \, \Delta\varphi(t)}}{2} \right. \right.$$

$$\left. \left. e^{j \, \varphi(t)} \; e^{j2\pi f_0 t} \right] \right.$$

$$e'(t) = \text{Réel} \left[ 2 \cos \Delta\phi(t) \; e^{j2\pi f_0 t + \phi(t)} \right]$$

Ainsi le signal émis est égal au signal que l'on voulait émettre. Dans le cas où le nombre M d'émetteurs 67 est supérieur à 2 le dispositif de transcodage 9 génère M signaux $x_i(t)$, i variant de 1 à M, permettant d'obtenir le signal à émettre par addition desdits signaux. Pour un nombre M d'émetteurs supérieur à 2 il existe une infinité d'ensembles de phase élémentaire ($\phi_1 \ldots \phi_M$).

Le choix d'un codage peut avantageusement minimiser la bande passante nécessaire des émetteurs 67.

Les signaux provenant de N sources de signal 8 sont multiplexés dans le temps et/ou transmis en parallèle.

Dans une variante de réalisation du dispositif selon la présente invention on utilise pour chaque émetteur une loi de modulation connue. Par exemple on utilise des lois de modulation binaire. Avantageusement on utilise pour tous les émetteurs 2 la modulation MSK (Minimum Shift Keying). Dans d'autres exemples de réalisation on utilise les lois de modulation CPFSK (Continus Phase Frequency Shift Keying) ou FSK (Frequency Shift Keying).

Avantageusement le dispositif de transcodage 91 est connecté en parallèle à M dispositifs de suréchantillonnage 92. Le dispositif de suréchantillonnage 92 effectue un suréchantillonnage du signal par exemple dans le rapport de 4 de 6 ou de 8.

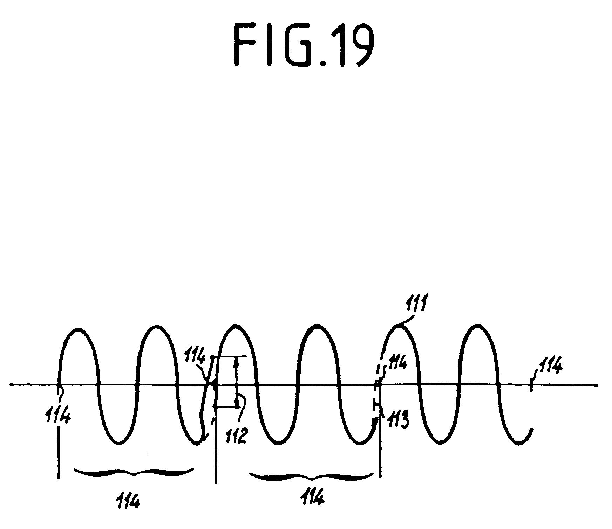

Avantageusement le dispositif de suréchantillonnage 92 est connecté à un dispositif de lissage du signal 93. Le dispositif de lissage du signal entre deux données transmises permet de réduire les sauts du signal, et ainsi de réduire la bande passante nécessaire aux transmissions. Les lissages du signal dans le dispositif 93 présentent l'inconvénient de réduire d'un facteur 2 les intervalles de temps dans lesquels l'information transmise est stable, ceci se traduit par une perte d'environ trois décibels au niveau de la réception. Les résultats de lissage sont illustrés sur la figure 19.

Avantageusement, le dispositif de lissage est connecté à un dispositif 94 de mise sur porteuse en numérique du signal. Les sorties du dispositif de mise en numérique sur porteuse du signal 94 sont connectées aux émetteurs 67 (non représentés sur la figure 14).

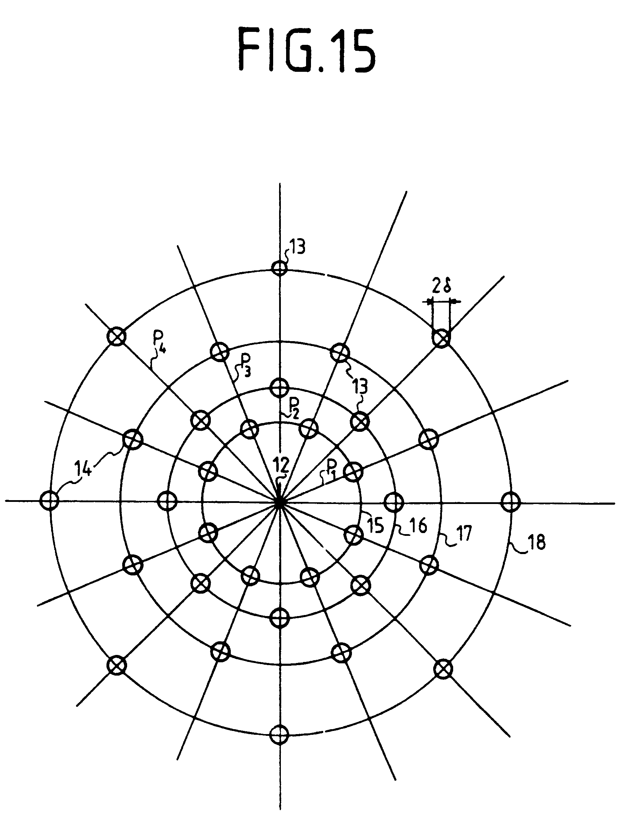

Sur la figure 15, on peut voir un exemple de répartition des valeurs numériques du signal dans le plan complexe obtenu avec deux émetteurs ou ensemble d'émetteurs 67. Le signal comporte 32 valeurs différentes ce qui correspond à une transmission numérique sur cinq bits. La valeur numérique correspondant à des disques 13 de diamètre égal à $2\delta$ répartis sur quatre cercles 15, 16, 17 et 18 de diamètre respectif $\rho1, \rho2, \rho3$ et $\rho4$. $\rho1$ est par exemple égal à $\sqrt{2/2}$, $\rho2 = 1$, $\rho3 = \sqrt{2}$ et $\rho4 = 2$, la puissance d'un émetteur étant normalisée à 1. Les points 14 sont répartis régulièrement sur chaque cercle.

Les valeurs numériques sont représentés par des disques 13 de diamètre $2\delta$ correspondant à une incertitude autour des points 14 correspondants du signal théorique émis par combinaison des signaux émis par les émetteurs 2 de la de la figure 7. En effet, il est primordial de pouvoir, à la réception déterminer la valeur numérique, c'est-à-dire le point 14 du plan complexe (amplitude, phase) qui a été émise et ce malgré la déformation de l'information. la déformation de l'information provient notamment des distorsions et du bruit thermique. La taille des disques 14 dépend de la probabilité d'erreur que l'on est près à accepter.

Par exemple à un rayon $\delta$ des disques 14 égal à :

$4,75\sigma$ ($\sigma$ étant l'écart type du bruit thermique) correspond une probabilité d'erreur de $10^{-6}$;

$7\sigma$ correspond une probabilité d'erreur de $10^{-12}$

et $10\sigma$ correspond une probabilité d'erreur de $10^{-23}$.

Une probabilité d'erreur de $10^{-6}$ peut être considérée comme trop forte pour les transmissions d'émission car elle correspond à des erreurs toujours présentes sur l'écran. Ces défauts peuvent complètement déformer l'image en télévision en haute définition utilisant la compression d'informations pour la transmission.

Le choix de $\delta$ influe sur le nombre d'état différent (de points 13) que l'on peut transmettre.

L'invention n'est pas limitée à des disques 14. Il est possible d'utiliser d'autres surface 14 dans un plan complexe pour déterminer la valeur numérique d'un point, comme par exemple des polygones.

EP 0 285 524 B1

Dans une première variante de réalisation du dispositif selon l'invention les disques 14 ne sont pas jointifs. A l'espace entre les disques 14 n'est attribué aucune valeur numérique. A la réception un signal n'appartenant pas à un disque 14 n'est pas traité.

Dans une seconde variante de réalisation du dispositif selon l'invention on utilise des régions 14 jointives.

Avantageusement, les points 13 sont les barycentres des régions 14.

Avantageusement, pour diminuer le risque d'erreur à la réception, on éloigne au maximum les disques 13. Ainsi, sur chaque cercle suivant les points 14 sont placés sur les bissectrices des points 14 du cercle précédent. Dans l'exemple illustré sur la figure 15 la discrimination de phase est égale à $\pi/8$, le rapport signal/bruit est compris entre 15 et 24 décibels.

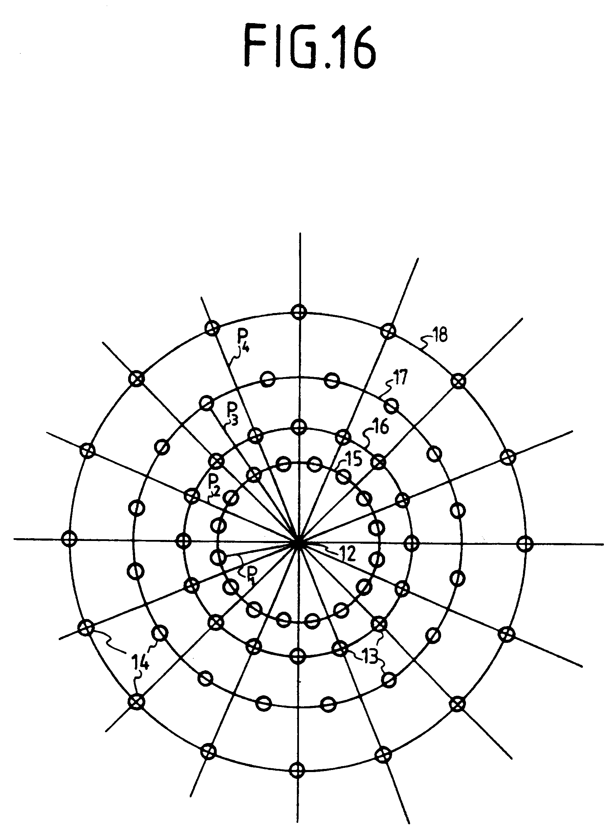

Sur la figure 16, on peut voir un exemple de répartition dans le plan complexe de valeurs numériques transmises sur six bits c'est-à-dire comportant 64 points 14 distincts. Les points 14 sont répartis sur quatre cercles référencés de 15 à 18 de diamètre respectif $\rho 1 = \sqrt{2}/2$, $\rho 2 = 1$, $\rho 3 = \sqrt{2}$, $\rho 4 = 2$, la puissance d'un émetteur 2 étant normalisée à 1. La précision de phase nécessaire est égale à $\pi/16$.

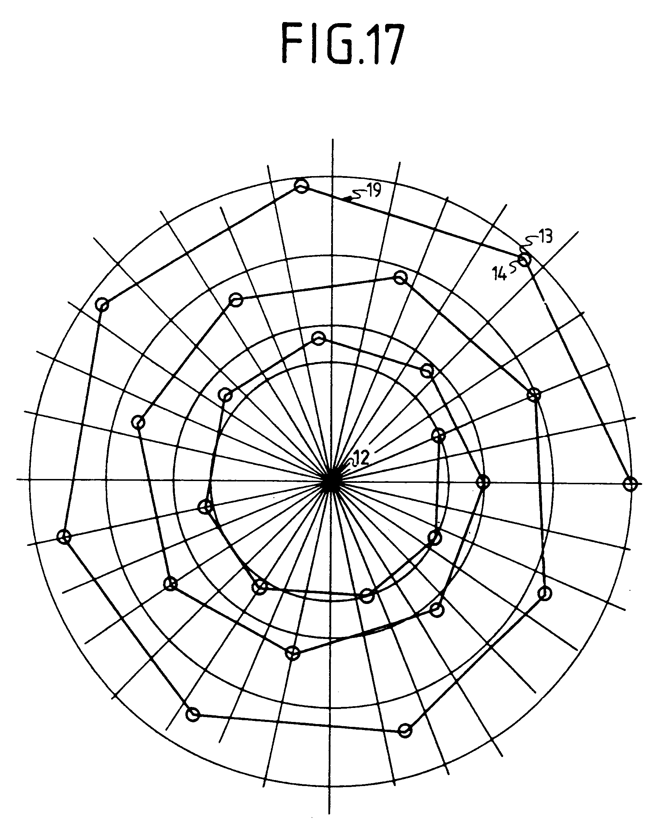

Sur la figure 17, on peut voir une répartition dans le plan complexe des diverses valeurs numériques à transmettre minimisant les risques de confusion. Les points 14 sont répartis sur une spirale de centre 12 comprise entre deux cercles correspondant à la puissance minimale nécessaire au rapport signal/bruit désiré et un cercle correspondant à la somme de puissance de tous les émetteurs utilisés. Avantageusement, la spirale est une spirale logarithmique. Sur la figure 17 on a représenté 24 points 14 distincts correspondant à un rapport signal/bruit de 30 décibels. La spirale utilisée était approximée par une courbe 19 réalisée en reliant les points 14.

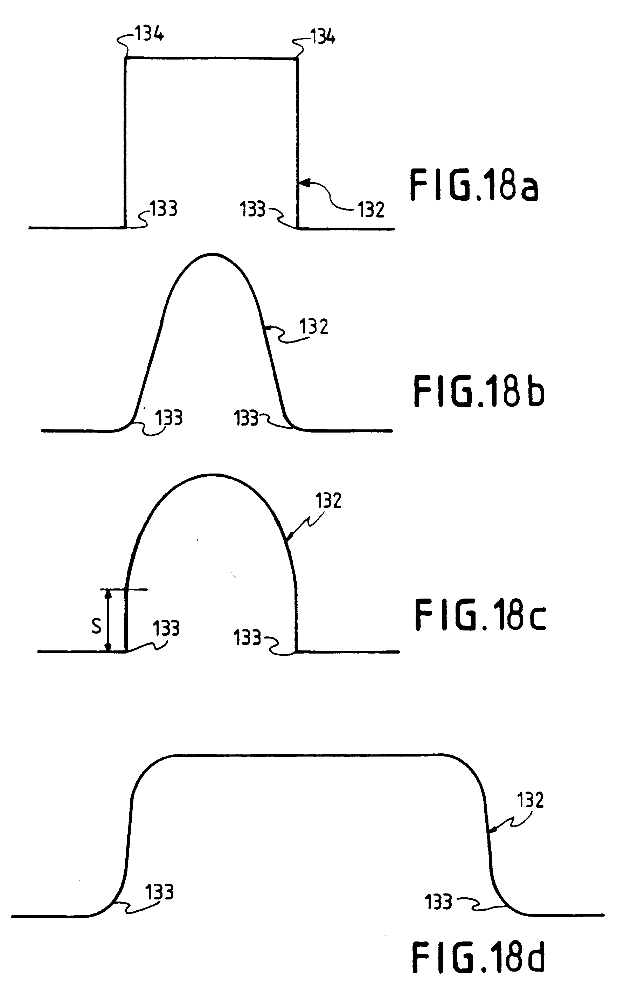

Sur la figure 18, on peut voir les diverses formes d'impulsion 132 susceptibles d'être émises, par exemple, par des dispositifs radar ou le dispositif de contrôle aérien.

Sur la figure 18a on peut voir une impulsion 132 rectangulaire. Les impulsions rectangulaires sont les plus faciles à générer. Toutefois, elles présentent l'inconvénient d'avoir un spectre fréquentiel très large, et donc de nécessiter une grande bande passante de l'émetteur ou de générer des lobes secondaires fréquentiels indésirables. En effet ces lobes secondaires perturbent le bon fonctionnement du dispositif travaillant sur des fréquences voisines.

L'élargissement du spectre est provoqué par la présence des transitions brusques notamment au niveau de la base de l'impulsion 133 aussi bien sur le front montant que sur le front descendant de l'impulsion ainsi que au moment 134 ou on arrive à l'énergie maximale émise.

Sur la figure 18b, on peut voir une impulsion 132, sensiblement gaussienne qui présente de très faibles lobes secondaires fréquentiel. L'impulsion 132 illustrée sur la figure 18b présente des transitions douces aussi bien au niveau de la base 133 de l'impulsion que au sommet de l'amplitude de l'impulsion. Une telle impulsion sensiblement gaussienne est susceptible d'être générée par le dispositif selon la présente invention.

Sur la figure 18c, on peut voir une impulsion obtenue par modulation appliquée à l'entrée des amplificateurs ou émetteurs 67 présentant un seuil S de déclenchement, comme par exemple l'amplificateur transistorisé ou certains amplificateurs à tubes. Lorsqu'on augmente le signal d'entrée d'un amplificateur ou émetteur 67 sans atteindre la valeur S du seuil aucun signal n'est émis. Dès que l'on a atteint la valeur du seuil un signal, correspondant à une amplitude non nulle est émise. Le passage brusque se caractérise au niveau de la forme de l'impulsion par une base rectangulaire présentant des angles droits en 133.

Sur la figure on a représenté l'amplitude obtenue à la sortie d'un amplificateur ou émetteur 67 en réponse au seuil S.

Bien qu'il soit possible de moduler les sommets de l'impulsion 132, la forme rectangulaire de la base de l'impulsion engendre des lobes secondaires importants au niveau fréquentiel. L'utilisation de combineur radial selon la présente invention permettra de s'approcher de la forme d'impulsion 132 de la figure 18b, l'énergie résiduelle étant absorbée par les résistances 69.

Sur la figure 18d, on peut voir une impulsion 132 longue présentant les formes arrondies permettant de limiter le spectre fréquentiel. Cette limitation des spectres n'est obtenue dans le cas des impulsions longues qu'avec une très faible perte de puissance. Toutefois elle peut entraîner une perte dans la résolution en distance pour un dispositif radar ne comportant pas de dispositif de compression d'impulsion.

Comme on l'a vu les résistances 69 des figures 1 et 2 sont destinées à absorber la puissance, allant jusqu'à trois décibels provenant de la modulation des impulsions. Il est bien entendu que dans le dispositif destiné à pouvoir marcher de cette manière, de façon continue il est impératif que les résistances 69 puissent dissiper cette puissance.

8

Dans les variantes de réalisation du dispositif selon la présente invention dans lesquelles on veut obtenir une modulation périodique du signal et non plus seulement une modulation des impulsions il est possible de récupérer l'énergie excédentaire se trouvant au niveau des transformateurs d'impédance 62 pour la réinjecter après un retard permettant la mise en phase avec le signal à émettre.

Sur la figure 19, on peut voir le principe du lissage effectué par le dispositif 93 du dispositif de traitement 9. Sur la figure 19, on a utilisé la même référence, 114, pour désigner des intervalles ou périodes de temps ainsi que pour désigner des instants délimitant ces intervalles de temps.

Pour simplifier la figure l'exemple illustré sur la figure 19 est une modulation de phase (et non une modulation amplitude-phase). Il est entendu que ce principe s'applique aussi à la modulation amplitude-phase.

Le lissage du signal permet de réduire la bande passante des émetteurs et l'autodistorsion du signal en transmissions numériques.

En transmission numérique en modulation de phase la valeur numérique à transmettre est fonction de la phase du signal à l'intérieur d'une période 114. Ainsi au point 114 le signal présente un saut de phase 112. La présence de ce saut de phase risque de perturber le bon fonctionnement du dispositif, notamment par autodistortion au cas où la bande passante du canal serait suffisante. Ainsi avantageusement le dispositif de traitement 9 de la figure 14 comporte un dispositif de lissage remplaçant le saut de phase 112 par une transition de phase 113. Le lissage est obtenu, par exemple, par interpolation entre les valeurs au niveau des points 114. Il est bien entendu que la phase étant modifiée autour des points 114. Ainsi il est important de ne point effectuer de mesure de phase à ces instants là. Dans le cas où la mesure de phase sera effectuée par l'intermédiaire d'un filtre adapté effectuant l'intégration du signal durant la période 114 il sera nécessaire de modifier le temps d'intégration du filtre de façon à n'intégrer que la partie de la partie de la période 114 durant laquelle la phase transmise est juste.

Il est bien entendu que la modulation d'amplitude des impulsions selon la présente invention peut être associée à d'autres modulations des impulsions comme par exemple la modulation de fréquence ou la modulation de phase. La modulation de phase permet par exemple d'obtenir une compression d'impulsion. De même la présente invention s'applique aux radars à agilité en fréquence, les impulsions émises à diverses fréquences étant modulées en amplitude de façon à minimiser les lobes secondaires.

L'invention s'applique notamment à la modulation d'impulsion, à la modulation amplitude et/ou phase des signaux radioélectriques.

L'invention s'applique principalement à la modulation d'impulsion radar et dispositif de contrôle aérien ainsi qu'à la transmission de donnée en modulation amplitude et/ou phase utilisable notamment pour la réalisation d'émissions radiophoniques ou des émissions de télévision à haute définition.

## Revendications

1. Dispositif d'émission d'ondes électromagnétiques comprenant un combineur radial pour ondes électromagnétiques comportant une pluralité d'entrées (63) connectées à une pluralité d'adaptateurs d'impédance (62), des émetteurs ou amplificateurs (67) étant connectés aux entrées (63) du combineur radial des points équipotentiels en fonctionnement normal des adaptateurs d'impédance étant reliés par des résistances (69) , caractérisé par le fait qu'au moins une partie desdits amplificateurs ou émetteurs (67) fonctionnent en classe C et sont reliés à des sources de signaux par l'intermédiaire d'un dispositif de traitement (9, 72) comportant un déphaseur (72, 91).

2. Dispositif selon la revendication 1, caractérisé par le fait que le dispositif de traitement (9) comporte des circuits (91 à 94) pour fournir à l'entrée des amplificateurs ou émetteurs (67) les signaux permettant d'obtenir à la sortie du combineur la modulation et/ou le codage désiré.

3. Dispositif selon la revendication 2, caractérisé par le fait que chaque amplificateur ou émetteur (67) reçoit un signal de commande individuel du circuit de traitement (9).

4. Dispositif selon la revendication 2 ou 3, caractérisé par le fait qu'il comporte un dispositif (82) de connexion du circuit de traitement (9) aux câbles coaxiaux reliés aux entrées des amplificateurs ou émetteurs (67), les connexions du circuit de traitement (9) étant réalisées en technologie microstrip.

5. Dispositif selon l'une quelconque des revendications précédentes, caractérisé par le fait qu'il comporte au moins un circuit de connexion (70, 71) entre le circuit de commande (9, 72) et les amplificateurs ou émetteurs (67), le circuit de connexion étant réalisé en technologie stripline.

**6.** Dispositif selon l'une quelconque des revendications précédentes, caractérisé par le fait que ledit dispositif est un radar.

**7.** Dispositif selon l'une des revendications précédentes, caractérisé par le fait que ledit dispositif est un émetteur de télévision.

**8.** Dispositif selon l'une des revendications 1 à 6, caractérisé par le fait que ledit dispositif est un émetteur radiophonique.

**9.** Utilisation du dispositf selon l'une des revendications 1 à 8 pour obtenir des signaux de sortie présentant des caractéristiques déterminées de forme et/ou d'amplitude et/ou de modulation.

**Claims**

**1.** Electromagnetic wave emission device comprising a radial combiner for electromagnetic waves including a plurality of inputs (63) connected to a plurality of impedance matchers (62), transmitters or amplifiers (67) being connected to the inputs (63) of the radial combiner, points which are equipotential during normal operation of the impedance matchers being linked by resistors (69), characterized in that at least part of the said amplifiers or transmitters (67) operate in class C and are linked to signal sources by way of a processing device (9,72) including a phase shifter (72,91).

**2.** Device according to Claim 1, characterized in that the processing device (9) includes circuits (91 to 94) for providing the input of the amplifiers or transmitters (67) with the signals enabling the desired modulation and/or coding to be obtained at the output of the combiner.

**3.** Device according to Claim 2, characterized in that each amplifier or transmitter (67) receives an individual control signal from the processing circuit (9).

**4.** Device according to Claim 2 or 3, characterized in that it includes a device (82) for connecting the processing circuit (9) to the coaxial cables linked to the inputs of the amplifiers or transmitters (67), the connecting up of the processing circuit (9) being carried out with microstrip technology.

**5.** Device according to any one of the preceding claims, characterized in that it includes at least one connecting circuit (70, 71) between the control circuit (9, 72) and the amplifiers or transmitters (67), the connecting circuit being produced with stripline technology.

**6.** Device according to any one of the preceding claims, characterized in that the said device is a radar.

**7.** Device according to one of the preceding claims, characterized in that the said device is a television transmitter.

**8.** Device according to one of Claims 1 to 6, characterized in that the said device is a radiophonic transmitter.

**9.** Use of the device according to one of Claims 1 to 8 to obtain output signals exhibiting specified characteristics of shape and/or amplitude and/or modulation.

**Patentansprüche**

**1.** Vorrichtung zur Aussendung elektromagnetischer Wellen, die einen Radialkombinator mit mehreren Eingängen (63) für elektromagnetische Wellen enthält, die an mehrere Impedanzanpassungskreise (62) angeschlossen sind, wobei Sender oder Verstärker (67) an die Eingänge (63) des Radialkombinators angeschlossen sind und im Normalbetrieb Äquipotentialpunkte der Impedanzanpassungskreise über Widerstände (69) miteinander verbunden sind, dadurch gekennzeichnet, daß mindestens einige der Verstärker oder Sender (67) in Klasse C betrieben werden und an Signalquellen über eine Verarbeitungsvorrichtung (9, 72) mit einem Phasenschieber (72, 91) eingeschlossen sind.

**2.** Vorrichtung nach Anspruch 1, dadurch gekennzeichnet, daß die Verarbeitungsvorrichtung (9) Schaltungen (91 bis 94) besitzt, die an den Eingang der Verstärker oder Sender (67) die Signale liefern, mit denen am Ausgang des Kombinators die gewünschte Modulation und/oder Kodierung erreicht wird.

**3.** Vorrichtung nach Anspruch 2, dadurch gekennzeichnet, daß jeder Verstärker oder Sender (67) ein eigenes Steuersignal vom Verarbeitungskreis (9) empfängt.

**4.** Vorrichtung nach Anspruch 2 oder 3, dadurch gekennzeichnet, daß sie eine Vorrichtung (82) zum Anschluß des Verarbeitungskreises (9) an die an die Eingänge der Verstärker oder Sender (67) angeschlossenen Koaxialkabel besitzt, wobei die Anschlüsse des Verarbeitungskreises (9) gemäß der Mikrostreifentechnologie erfolgen.

**5.** Vorrichtung nach einem beliebigen der vorhergehenden Ansprüche, dadurch gekennzeichnet, daß sie mindestens einen Anschlußkreis (70, 71) zwischen dem Steuerkreis (9, 72) und den Verstärkern oder Sendern (67) aufweist, wobei der Anschlußkreis in Streifenleitungstechnik (im englischen "strip line") ausgebildet ist.

**6.** Vorrichtung nach einem beliebigen der vorhergehenden Ansprüche, dadurch gekennzeichnet, daß die Vorrichtung ein Radargerät ist.

**7.** Vorrichtung nach einem der Ansprüche 1 bis 5, dadurch gekennzeichnet, daß die Vorrichtung ein Fernsehsender ist.

**8.** Vorrichtung nach einem der Ansprüche 1 bis 5, dadurch gekennzeichnet, daß die Vorrichtung ein Rundfunksender ist.

**9.** Verwendung der Vorrichtung nach einem der Ansprüche 1 bis 8 zur Erzeugung von Ausgangssignalen, die bestimmte Merkmale der Form und/oder Amplitude und/oder Modulation besitzen.

FIG.1

FIG.2

# FIG.3

Déphaseur 72

74

Oscilateur 73

# FIG.4

# FIG.5

FIG.6

FIG.7

FIG.8

FIG.9

FIG.10

FIG.11

FIG.12

FIG.13

# FIG.14

SURECHANTILLONAGE — LISSAGE — NUMERIQUE

TRANSCODAGE

EP 0 285 524 B1

# FIG.15

# FIG.16

# FIG.17

FIG.18a

FIG.18b

FIG.18c

FIG.18d

# FIG.19